# EUROPÄISCHE PATENTSCHRIFT

(11) **EP 3 375 081 B1**
(45) Veröffentlichungstag und Bekanntmachung des Hinweises auf die Patenterteilung: **13.01.2021**
(21) Anmeldenummer: 16790331.9
(22) Anmeldetag: 31.10.2016
(51) Int. Cl.: H02K 41/03, H02K 3/26, H01F 27/28, H05K 3/46, H05K 1/16

(54) **PLANAR-POSITIONIERVORRICHTUNG UND POSITIONIERTISCH**
PLANAR POSITIONING APPARATUS AND POSITIONING TABLE
DISPOSITIF DE POSITIONNEMENT PLAN ET TABLE DE POSITIONNEMENT

(30) Priorität: 13.11.2015 DE 102015222482
(43) Veröffentlichungstag der Anmeldung: 19.09.2018
(73) Patentinhaber: Physik Instrumente (PI) GmbH & Co. KG, 76228 Karlsruhe (DE)
(72) Erfinder: GLÖSS, Rainer, 76228 Karlsruhe (DE)
(74) Vertreter: Kruspig, Volkmar
(86) Internationale Anmeldenummer: PCT/EP2016/076193
(87) Internationale Veröffentlichungsnummer: WO 2017/080859

(56) Entgegenhaltungen:
- WO-A1-00/10242
- WO-A1-2013/059934
- US-A1- 2012 139 365
- US-A1- 2013 257 575

## Beschreibung

Die Erfindung betrifft eine Planar-Positioniervorrichtung, mit einem Stator, der eine Spulenanordnung aus Flachspulen umfasst, einem in Betriebslage der Positioniervorrichtung dem Stator gegenüberliegend angeordneten Läufer, der eine planare Magnetanordnung aus mehreren Magnetreihen aufweist, wobei die durch die planare Magnetanordnung aufgespannte Ebene parallel zur Ebene der Spulenanordnung angeordnet ist, einer Positionserfassungseinrichtung zur Erfassung der Lage des Läufers relativ zum Stator, und einer Auswertungs- und Steuereinrichtung zur Auswertung von Positionssignalen der Positionserfassungseinrichtung und zur Steuerung einer Bestromung der Spulenanordnung zur Positionssteuerung des Läufers bezüglich des Stators.

Zahlreiche Typen von Werkzeugmaschinen oder anderen Bearbeitungs- oder Messanordnungen sind mit Positioniertischen, auch bezeichnet als Kreuztisch oder XY-Tisch, zur geeigneten Positionierung eines Werkstücks bezüglich eines Werkzeugs oder auch eines Messobjekts bezüglich einer Messeinrichtung ausgestattet. Fortgeschrittene Positioniertische dieser Art bieten nicht nur eine reine XY-Positionierung, sondern mehrachsige Positionierung, und werden in ihrer höchsten Entwicklungsstufe auch als 6D-Positionierer oder -Tische bezeichnet.

Während traditionelle XY- oder Kreuztische mit zwei Linearantrieben ausgestattet sind, gewinnen seit einiger Zeit Antriebskonzepte an praktischer Bedeutung, die auf Flachspulenanordnungen und Flächen-Arrays von Permanentmagneten auf Stator- bzw. Läuferseite basieren. Sogenannte "Flächenmotoren" oder Planarantriebe umfassen nur ein einzelnes Motor-Primärteil (Stator) und ein mit Permanentmagneten bestücktes Motor-Sekundärteil (Läufer), so dass ein zweiter Antriebsmotor ebenso entfällt wie zusätzliche mechanische Übertragungselemente, wie sie beispielsweise bei Kugelgewindetrieben benötigt werden. Planar-Positioniervorrichtungen der genannten oder ähnlicher Art sind beispielsweise aus der WO 00/10242 A1, US 2012/139365 A1, US 6,452,292 B1, US 2007/0035267 A1, US 2006/0049699 A1 und WO 2009/115071 A2 bekannt.

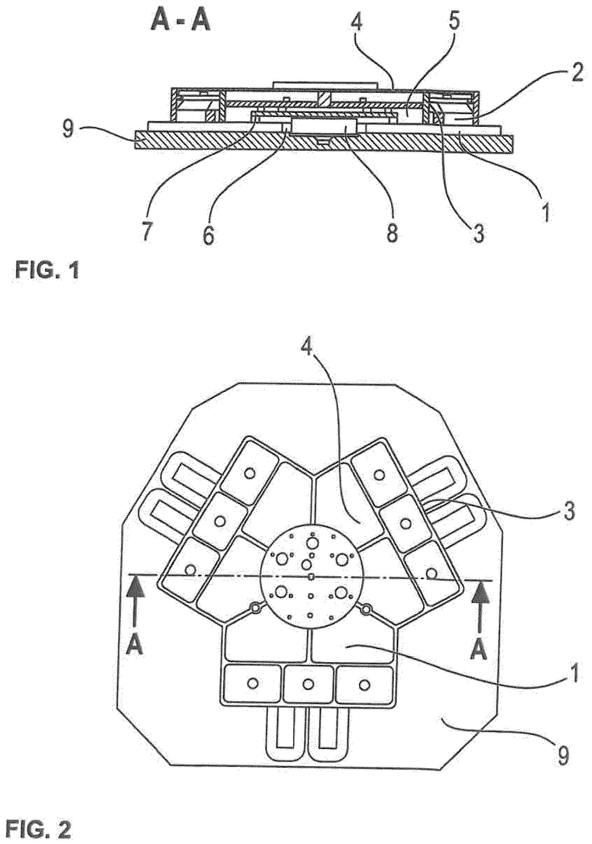

Auch die auf die Anmelderin zurückgehende DE 10 2011 100 153 A1 offenbart eine gattungsgemäße Planar-Positioniervorrichtung. Der Aufbau dieser Planer-Positioniervorrichtung ist in Fig. 1 und 2 schematisch gezeigt.

Eine planare Spulenanordnung 1, die hier aus sechs Flachspulen besteht, die in drei Paaren sternförmig um jeweils 120° versetzt angeordnet sind, ist auf einer Statorplatte 9 angeordnet und befestigt. Im Zentrum der Spulenanordnung ist ein freigelassener Raum bzw. ein Fenster 6 belassen, in dem auf der Statorplatte ein Positionsmesskopf (6D-Messkopf) 8 angebracht ist. Über der Statorplatte 9 mit der Spulenanordnung 1 ist, dieser gegenüber bewegbar, ein Läufer 3 mit einer planaren Magnetanordnung 2 angeordnet, die aus drei Reihen von wechselseitig polarisierten Magneten gebildet ist, die in Mittellage des Läufers 3 jeweils mittig zu einem Spulenpaar der Spulenanordnung 1 positioniert sind. Auch im Zentrum der Magnetanordnung 2 befindet sich ein Freiraum bzw. ein Fenster 5, der bzw. das Platz für einen Flächenmaßstab 7 bietet, der im Zusammenwirken mit dem Positionsmesskopf 8 zur Positionsmessung des Läufers 3 relativ zum Stator 9 dient. Auf der Oberseite des Läufers 2 ist ein Objekt- bzw. Werkstückträger 4 angeordnet.

Die WO 2013/0059934 A1 beschreibt ebenfalls eine Planar-Positioniervorrichtung der oben beschriebenen Art, bei der die Spulenanordnung aus in mehreren Ebenen des Stators verlaufenden Leiterzügen ausgeführt ist, die eine Vielzahl von Flachspulen in einer ersten und einer hierzu senkrechten zweiten Ausrichtung der Leiterzüge bzw. Spulenwindungen umfasst. Soweit ersichtlich, erstreckt sich die Spulenanordnung über vier oder mehr Leiterebenen des Stators. Wie die Anschlüsse zur Bestromung der Vielzahl von Spulen ausgeführt sind, ist der Druckschrift nicht im Einzelnen zu entnehmen.

Der Erfindung liegt die Aufgabe zugrunde, eine Planar-Positioniervorrichtung mit vereinfachtem Aufbau insbesondere des Stators und mit erleichterter Herstellung und somit niedrigeren Gestehungskosten anzugeben.

Die Aufgabe wird durch eine Planar-Positioniervorrichtung mit den Merkmalen des Anspruchs 1 gelöst. Zweckmäßige Fortbildungen des Erfindungsgedankens sind Gegenstand der abhängigen Ansprüche. Es wird weiterhin ein vorteilhafter Positioniertisch vorgeschlagen.

Die Erfindung schließt den Gedanken ein, im Interesse einer Vereinfachung des Statoraufbaus und damit einhergehenden Kostenreduzierung die Anzahl der Leiterebenen zur Realisierung der Spulenanordnung zu verringern. Dabei soll, gemäß einer weiteren grundlegenden Überlegung der Erfinder, möglichst eine herkömmliche Leiterplatte mit zwei Leiterebenen und einer dazwischenliegenden Isolierschicht als Basis dienen können.

Weiterhin gehört zur Erfindung der Gedanke, dies durch eine Ineinander-Verschachtelung der zusammengehörenden Flachspulen der drei Phasen mit gleicher Ausrichtung (d. h. gleicher Erstreckungsrichtung des wesentlichen Längsverlaufes der Leiterzüge) zu erreichen. Schließlich schließt die Erfindung den Gedanken einer besonderen geometrischen Konfiguration der unvermeidlichen Überkreuzungsbereiche von Leiterzügen der ineinander verschachtelten Flachspulen ein, welche es ermöglichen, ohne eine zusätzliche (speziell dritte) Leiterebene auszukommen.

Insgesamt ist also erfindungsgemäß vorgesehen, dass die Spulenanordnung je n x 3 (n ≥ 1) miteinander verschachtelte, langgestreckte Flachspulen in einer ersten und zweiten Ausrichtung der Spulenanordnung umfasst, die im größten Teil ihres Verlaufes als Leiterzüge einer ersten Ebene einer Mehrebenen-Leiterplatte ausgeführt sind, und die Leiterzüge der drei zusammengehörenden Flachspulen Überkreuzungsbereiche einschließen, die in einer zweiten Ebene der Mehrebenen-Leiterplatte verlaufen. Speziell verlaufen die n x 3 Flachspulen der ersten Ausrichtung im größten Teil ihres Verlaufes in der ersten Ebene und die zugehörigen Überkreuzungsbereiche in der zweiten Ebene der Mehrebenen-Leiterplatte, während die n x 3 Flachspulen der zweiten Ausrichtung im größten Teil Ihres Verlaufes in der zweiten Ebene und die zugehörigen Überkreuzungsbereiche in der ersten Ebene der Mehrebenen-Leiterplatte verlaufen.

Mit diesem Aufbau wird es ermöglicht, den Stator bzw. den die Spulenanordnung tragenden Teil einer Planar-Positioniervorrichtung der gattungsgemäßen Art im einfachsten Fall mit einer einzigen herkömmlichen Zweiebenen-Leiterplatte, jedenfalls aber aus Leiterplatten mit einer verringerten Anzahl von Leiterebenen aufzubauen. Dies spart neben Materialkosten für die zugrunde liegende Mehrebenen-Leiterstruktur auch Bauhöhe und ermöglicht einen kompakteren Aufbau der Positioniervorrichtung. Die Lösung spart auch Arbeitsaufwand bei der Herstellung der Spulenanordnung, insbesondere bei der Ausführung von deren Anschlüssen. Insgesamt ergibt sich eine signifikante Vereinfachung des Herstellungsprozesses und Verringerung der Gestehungskosten.

Insbesondere liegt hierbei jeweils ein Teil der Anschlussenden aller Flachspulen in der ersten Ebene der Mehrebenen-Leiterplatte und ein anderer Teil in deren zweiter Ebene. Vorteilhafterweise sind zudem alle Anschlussenden der drei zusammengehörenden Flachspulen der drei Phasen jeweils in einem kleinen Anschlussbereich der Mehrebenen-Leiterplatten konzentriert. Dies vereinfacht die Bestückung der Anschlussenden mit entsprechenden Anschlusskontakten und somit insgesamt den Aufbau und die Handhabung des Stators der Positioniervorrichtung.

Im Interesse eines einfachen Abgleichs und Betriebs der Spulenanordnung sind bevorzugt alle Flachspulen mit im Wesentlichen gleicher Länge und gleichem ohmschen Widerstand ausgeführt. Vereinfachungen beim Entwurf, den Herstellungsschritten und auch der Qualitätsprüfungen erbringt eine Ausführung, bei der alle Flachspulen mit weitgehend rechteckförmigem Leiterverlauf ausgeführt sind.

Bei einer weiteren Ausführung, bei der die Spulenanordnung im Wesentlichen die gesamte Fläche des Stators bedeckt, wird ein grundsätzlich weiterer Verfahrbereich realisiert. Dieser lässt sich speziell in einer Ausführung optimieren, in der die Positionserfassungseinrichtung wenigstens einen in Betriebslage der Positioniervorrichtung innerhalb des Stators oder Läufers angeordneten Positionsmesskopf und einen positionstreu an dem Läufer oder an dem Stator fixierten Flächenmaßstab umfasst und in der der Stator oder der Läufer wenigstens ein Fenster und bevorzugt eine Mehrzahl von Fenstern in Matrixanordnung zur Sichtbarmachung des Flächenmaßstabes für den Positionsmesskopf aufweist.

In einer bevorzugten Ausgestaltung mit einer Mehrzahl von regulär angeordneten Beobachtungsfenstern für den Flächenmaßstab sind diese Fenster - oder jedenfalls ein Teil hiervon - durch Aussparungen zwischen einzelnen Spulensets und/oder zwischen Dreiergruppen von jeweils drei phasenmäßig zusammengehörenden Flachspulen geschaffen. Dies ermöglicht eine dichte Aneinanderreihung der n Flachspulen-Teilanordnungen und damit einerseits eine hochgradige Ausnutzung der Statorfläche und andererseits eine ausreichend dichte Platzierung von Beoachtungsfenstern.

In einer weiteren Ausführung umfasst der Läufer eine schachbrettartige Anordnung von Magnetreihen, insbesondere vier quadratische Magnetreihen in Schachbrettanordnung. In einer vorteilhaften geometrischen Konfiguration bedecken die Magnetreihen den zentralen Bereich des Läufers im Wesentlichen. In vorteilhafter Weise bildet hierbei jede Magnetreihe ein sogenanntes Halbach-Array.

Der im Rahmen der Erfindung weiterhin vorgeschlagene Positioniertisch umfasst neben einer Planar-Positioniervorrichtung der oben beschriebenen Art Halte- und Führungsmittel für die Planar-Positioniervorrichtung und eine Objekthalterung zum Halten eines zu positionierenden Objekts. Ein solcher Positioniertisch kann einen wesentlichen Teil einer Bearbeitungsanordnung, insbesondere Werkzeugmaschine, oder auch einer Messanordnung, speziell zum Ausmessen komplexer Werkstücke, bilden und ermöglicht somit deren Herstellung in vereinfachter Weise und mit verringertem Kostenaufwand.

Vorteile und Zweckmäßigkeiten der Erfindung ergeben sich im Übrigen aus der nachfolgenden skizzenhaften Beschreibung von Ausführungsbeispielen anhand der Figuren. Von diesen zeigen:
Fig. 1 und 2 eine schematische Schnittdarstellung bzw. Draufsicht einer bekannten Planar-Positioniervorrichtung und
Fig. 3 eine schematische Darstellung (Ausschnittdarstellung in Art einer Draufsicht) einer Spulenanordnung gemäß einer Ausführungsform der Erfindung und Fig. 3A eine Detailansicht hieraus.

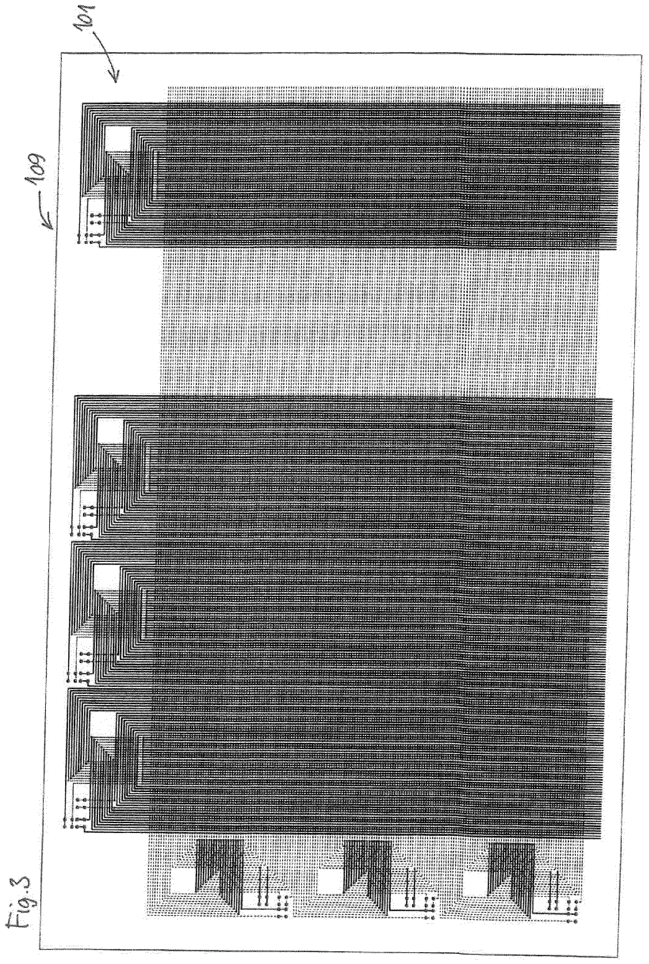

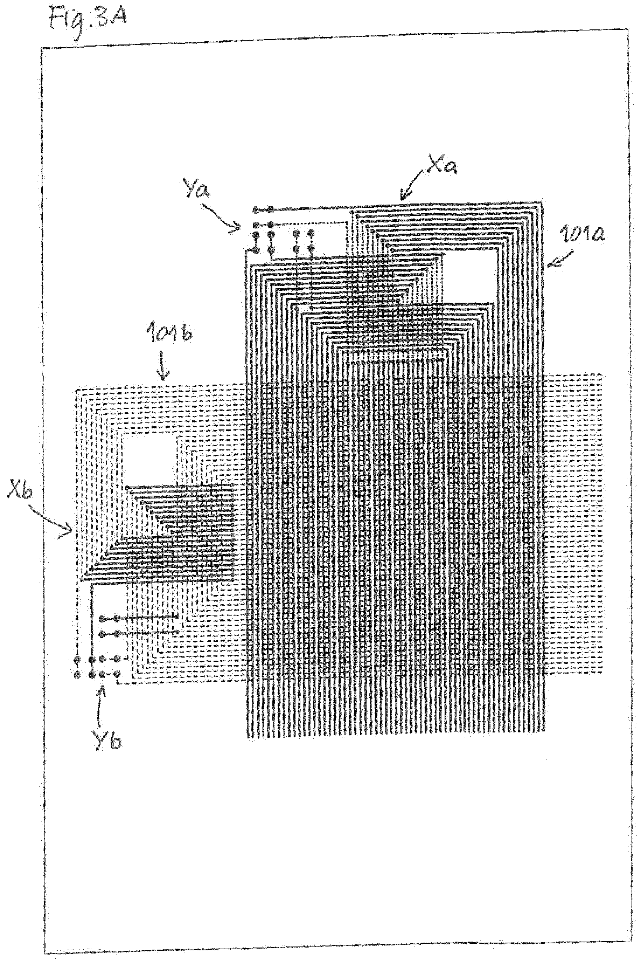

Fig. 3, in der Bezugsziffern in Anlehnung an die Bezeichnung bestimmter Teile der Planar-Positioniervorrichtung aus Fig. 1 und 2 vergeben sind, zeigt einen Teil einer Spulenanordnung 101 auf einer Statorplatte 109, die Gruppen senkrecht zueinander verlaufender langgestreckter Spulen-Teilanordnungen (in Fig. 3 nicht gesondert bezeichnet) umfasst. Sämtliche sich in der einen Richtung (in Fig. 3 und 3A in vertikaler Richtung) erstreckenden Flachspulen sind im Wesentlichen durch Leiterzüge auf einer ersten Ebene einer Zweiebenen-Leiterplatte realisiert, und sämtliche sich in der anderen Richtung (in Fig. 3 und 3A in horizontaler Richtung) erstreckenden Flachspulen sind im größten Teil ihrer Erstreckung als Leiterzüge auf der zweiten Ebene jener Zweiebenen-Leiterplatte realisiert. Die ersteren Leiterzüge sind als durchgezogene Linien dargestellt, während die Leiterzüge auf der zweiten Ebene als gestrichelte Linien dargestellt sind. In der Ausschnittdarstellung der Fig. 3A ist eine Spulen-Teilanordnung (ein Spulenset) des ersten Typs mit Ziffer 101a bezeichnet, während eine Spulen-Teilanordnung des zweiten Typs, mit zum ersten Typ senkrecht ausgerichtetem Windungsverlauf, mit Ziffer 101b bezeichnet ist.

Es ist zu erkennen, dass jede Spulen-Teilanordnung 3 ineinander verschachtelte Spulen mit jeweils weitestgehend rechteckigem Leiterverlauf umfasst.

Im größten Teil der Erstreckung der Flachspulen sind deren Leiter unproblematisch durch Parallel-Anordnung von in die jeweilige Leitebene der Leiterplatte strukturierten Leiterzügen realisierbar. Jedoch ist in Überkreuzungsbereichen Xa, Xb und in Anschlussbereichen Ya, Yb bei einem Teil der Anschlussenden der einzelnen Flachspulen jedes Spulensets ein Verlassen der entsprechenden Haupt-Erstreckungsebene erforderlich, damit keine Kurzschlüsse zwischen Leiterzügen auftreten. Dies ist in den Figuren durch die entsprechend geänderte Darstellung des Linienverlaufs zur Darstellung der Leiterzüge kenntlich gemacht.

Die Anschlussbereiche Ya, Yb der jeweiligen Spulen-Teilanordnungen 101a bzw. 101b nehmen in der hier gezeigten Ausführung eine Fläche von weniger als 5 %, speziell eine Fläche von ca. 2,5 %, der Fläche der Erstreckung der jeweiligen Spulen-Teilanordnung ein, sind also als kleine Anschlussbereiche zu qualifizieren. Ihre Form kann in der Draufsicht näherungsweise als rechteckig angesehen werden.

Technologisch ist der "Sprung" in die jeweils gegenüberliegende Ebene (also von der ersten in die zweite bzw. von der zweiten in die erste Ebene) durch herkömmliche Durchkontaktierungen (Vias) realisierbar, also über Durchbrüche im isolierenden Trägermaterial, die mit leitfähigem Material ausgefüllt sind. Es ist zu betonen, dass die erfindungsgemäße Ineinander-Verschachtelung der Flachspulen eines Spulensets geometrisch derart konfiguriert ist, dass sämtliche Überkreuzungsbereiche in einer einzigen zusätzlichen Leiterebene ausführbar sind, also - anders als bei einer herkömmlichen Ineinander-Verschachtelung dreier zusammengehöriger Flachspulen - keine dritte Leiter- bzw. Windungsebene benötigt wird.

Die Ausführung der Erfindung ist nicht auf dieses Beispiel beschränkt, sondern ebenso in einer Vielzahl von Abwandlungen möglich, die im Rahmen fachgemäßen Handelns liegen.

## Patentansprüche

1. Planar-Positioniervorrichtung, mit
einem Stator (9), der eine Spulenanordnung (1;101) aus Flachspulen umfasst,
einem in Betriebslage der Positioniervorrichtung dem Stator gegenüberliegend angeordneten Läufer (3), der eine planare Magnetanordnung (2) aus mehreren Magnetreihen aufweist, wobei die durch die planare Magnetanordnung aufgespannte Ebene parallel zur Ebene der Spulenanordnung angeordnet ist,
einer Positionserfassungseinrichtung (7,8) zur Erfassung der Lage des Läufers relativ zum Stator, und
einer Auswertungs- und Steuereinrichtung zur Auswertung von Positionssignalen der Positionserfassungseinrichtung und zur Steuerung einer Bestromung der Spulenanordnung zur Positionssteuerung des Läufers bezüglich des Stators,
wobei die Spulenanordnung (1;101) je n x 3, wobei n≥1 ist, miteinander verschachtelte, langgestreckte Flachspulen (101a,101b) in einer ersten und zweiten Ausrichtung der Spulenanordnung umfasst, die im größten Teil ihres Verlaufes als Leiterzüge einer ersten Ebene einer Mehrebenen-Leiterplatte ausgeführt sind, und die Leiterzüge der drei zusammengehörenden Flachspulen Überkreuzungsbereiche (Xa,Xb) einschließen, die in einer zweiten Ebene der Mehrebenen-Leiterplatte verlaufen, wobei alle Anschlussenden der drei zusammengehörenden Flachspulen jeweils in einem kleinen Anschlussbereich der Mehrebenen-Leiterplatten konzentriert sind, **dadurch gekennzeichnet, dass** die n x 3 Flachspulen der ersten Ausrichtung (101a) im größten Teil ihres Verlaufes in der ersten Ebene und die zugehörigen Überkreuzungsbereiche (Xa) in der zweiten Ebene der Mehrebenen-Leiterplatte verlaufen, während die n x 3 Flachspulen der zweiten Ausrichtung (101b) im größten Teil Ihres Verlaufes in der zweiten Ebene und die zugehörigen Überkreuzungsbereiche in der ersten Ebene der Mehrebenen-Leiterplatte verlaufen.

2. Planar-Positioniervorrichtung nach Anspruch 1, wobei jeweils ein Teil der Anschlussenden (Ya,Yb) aller Flachspulen (101a,101b) in der ersten Ebene der Mehrebenen-Leiterplatte und ein anderer Teil in deren zweiter Ebene liegt.

3. Planar-Positioniervorrichtung nach einem der vorangehenden Ansprüche, wobei alle Flachspulen (101a,101b) mit gleicher Länge und gleichem ohmschen Widerstand ausgeführt sind.

4. Planar-Positioniervorrichtung nach einem der vorangehenden Ansprüche, wobei alle Flachspulen (101a,101b) mit rechteckförmigem Leiterverlauf ausgeführt sind.

5. Planar-Positioniervorrichtung nach einem der vorangehenden Ansprüche, wobei der kleine Anschlussbereich (Ya,Yb) der Mehrebenen-Leiterplatte eine Fläche von weniger als 10 %, insbesondere von weniger als 5 %, der von den Flachspulen eingenommenen Fläche einnimmt und insbesondere rechteckig ausgebildet ist.

6. Planar-Positioniervorrichtung nach einem der vorangehenden Ansprüche, wobei die Mehrebenen-Leiterplatte eine Zweiebenen-Leiterplatte ist.

7. Planar-Positioniervorrichtung nach einem der vorangehenden Ansprüche, wobei die Spulenanordnung (1;101) die gesamte Fläche des Stators (9) bedeckt.

8. Planar-Positioniervorrichtung nach einem der vorangehenden Ansprüche, wobei die Positionserfassungseinrichtung (7,8) wenigstens einen in Betriebslage der Positioniervorrichtung innerhalb des Stators oder Läufers angeordneten Positionsmesskopf (8) und einen positionstreu an dem Läufer oder an dem Stator fixierten
Flächenmaßstab (7) umfasst und wobei der Stator oder der Läufer wenigstens ein Fenster (5) und bevorzugt eine Mehrzahl von Fenstern in Matrixanordnung zur Sichtbarmachung des Flächenmaßstabes für den Positionsmesskopf aufweist.

9. Planar-Positioniervorrichtung nach Anspruch 8, wobei mindestens ein Teil der Mehrzahl von Fenstern in Matrixanordnung entweder zwischen benachbarten Flachspulen der jeweils drei zusammengehörenden Flachspulen oder zwischen den jeweils n benachbarten Gruppen mit jeweils drei zusammengehörenden Flachspulen angeordnet ist.

10. Planar-Positioniervorrichtung nach einem der vorangehenden Ansprüche, wobei der Läufer (3) eine schachbrettartige Anordnung von Magnetreihen, von denen insbesondere jede ein Halbach-Array (2) bildet, umfasst, insbesondere vier quadratische Magnetreihen in Schachbrettanordnung.

11. Planar-Positioniervorrichtung nach Anspruch 10, wobei die Magnetreihen den zentralen Bereich des Läufers (3) bedecken.

12. Positioniertisch (4) mit einer Planar-Positioniervorrichtung nach einem der vorangehenden Ansprüche, wobei der Positioniertisch Halte- und Führungsmittel für die Planar-Positioniervorrichtung und eine Objekthalterung zum Halten eines zu positionierenden Objekts aufweist.

13. Bearbeitungsanordnung, insbesondere Werkzeugmaschine, mit einem Positioniertisch (4) nach Anspruch 12.

14. Messanordnung mit einem Positioniertisch (4) nach Anspruch 12.

## Claims

1. Planar positioning apparatus, comprising
a stator (9) which comprises a coil arrangement (1; 101) of flat coils,
a rotor (3) which is arranged opposite the stator in the operating position of the positioning apparatus and has a planar magnet arrangement (2) comprising a plurality of rows of magnets, wherein the plane which is spanned by the planar magnet arrangement is arranged parallel to the plane of the coil arrangement,
a position detecting device (7, 8) for detecting the position of the rotor relative to the stator, and
an evaluation and control device for evaluating position signals of the position detecting device and for controlling a current supply to the coil arrangement for controlling the position of the rotor with respect to the stator,
wherein the coil arrangement (1; 101) comprises in each case n x 3, with n ≥ 1, elongate flat coils (101a, 101b) which are interleaved with one another, in a first and second orientation of the coil arrangement, which over the majority of their extent, are designed as conductor tracks of a first plane of a multiple-plane printed circuit board, and the conductor tracks of the three associated flat coils enclose crossover regions (Xa, Xb) which run in a second plane of the multiple-plane printed circuit board, wherein all of the connection ends of the three associated flat coils each are concentrated in a small connection region of the multiple-plane printed circuit board,
**characterized in that**
the n x 3 flat coils of the first orientation (101a) run over the majority of their extent in the first plane and the associated crossover regions (Xa) in the second plane of the multiple-plane printed circuit board, while the n x 3 flat coils of the second orientation (101b) run over the majority of their extent in the second plane and the associated crossover regions in the first plane of the multiple-plane printed circuit board.

2. Planar positioning apparatus according to claim 1, wherein in each case a part of the connection ends (Ya, Yb) of all of the flat coils (101a, 101b) is in the first plane of the multiple-plane printed circuit board, and another part in the second plane thereof.

3. Planar positioning apparatus according to anyone of the preceding claims, wherein all of the flat coils (101a, 101b) are realized to have the same length and the same ohmic resistance.

4. Planar positioning apparatus according to anyone of the preceding claims, wherein all of the flat coils (101a, 101b) are realized to have a rectangular conductor extent.

5. Planar positioning apparatus according to anyone of the preceding claims, wherein the small connection area (Ya, Yb) of the multiple-plane printed circuit board occupies a surface of less than 10 %, in particular of less than 5 % of the surface occupied by the flat coils and is in particular formed to be rectangular.

6. Planar positioning apparatus according to anyone of the preceding claims, wherein the multiple-plane printed circuit board is a dual-plane printed circuit board.

7. Planar positioning apparatus according to anyone of the preceding claims, wherein the coil arrangement (1; 101) covers the entire surface of the stator (9).

8. Planar positioning apparatus according to anyone of the preceding claims, wherein the position detecting device (7, 8) comprises at least one position measuring head (8) arranged within the stator or the rotor in the operating position of the positioning device, and an area scale (7) fixed true to position to the rotor or the stator, and wherein the stator or the rotor has at least one window (5), and preferably a plurality of windows in a matrix arrangement for making the area scale visible for the position measuring head.

9. Planar positioning apparatus according to claim 8, wherein at least a part of the plurality of windows in the matrix arrangement is either disposed between adjacent flat coils of in each case three associated flat coils or between the in each case n adjacent groups each comprising three associated flat coils.

10. Planar positioning apparatus according to anyone of the preceding claims, wherein the rotor (3) comprises a chessboard-like arrangement of rows of magnets, each of which in particular forming a Halbach array (2), in particular four square rows of magnets in a chessboard arrangement.

11. Planar positioning apparatus according to claim 10, wherein the rows of magnets cover the central area of the rotor (3).

12. Positioning table (4) comprising a planar positioning apparatus according to anyone of the preceding claims, wherein the positioning table has holding and guiding means for the planar positioning apparatus und an object holder for holding an object to be positioned.

13. Machining arrangement, in particular machine tool, comprising a positioning table (4) according to claim 12.

14. Measuring arrangement comprising a positioning table (4) according to claim

## Revendications

1. Dispositif de positionnement planaire, comportant
un stator (9) qui comprend un ensemble de bobines (1 ; 101) constitué de bobines plates,
un rotor (3) qui est disposé en face du stator dans la position de fonctionnement du dispositif de positionnement et qui présente un ensemble d'aimants planaire (2) constitué de plusieurs rangées d'aimants, le plan défini par l'ensemble d'aimants planaire étant disposé parallèlement au plan de l'ensemble de bobines,
un moyen de détection de position (7, 8) pour détecter la position du rotor par rapport au stator, et
un moyen d'évaluation et de commande pour évaluer des signaux de position du moyen de détection de position et pour commander une alimentation en courant de l'ensemble de bobines pour commander la position du rotor par rapport au stator,
dans lequel
l'ensemble de bobines (1 ; 101) comprend respectivement n x 3 bobines plates allongées (101a, 101b), sachant que n ≥ 1, qui sont imbriquées les unes avec les autres et disposées dans une première et dans une seconde orientation de l'ensemble de bobines et qui, sur la majeure partie de leur extension, sont réalisées sous forme de pistes conductrices d'un premier plan d'une carte à circuit multi-plans, et les pistes conductrices des trois bobines plates associées incluent des zones de croisement (Xa, Xb) s'étendant dans un second plan de la carte à circuit multi-plans, toutes les extrémités de connexion des trois bobines plates associées étant concentrées chacune dans une petite zone de connexion des cartes à circuit multi-plans,
**caractérisé en ce que**
lesdites n x 3 bobines plates de la première orientation (101a) s'étendent, sur la majeure partie de leur extension, dans le premier plan et les zones de croisement associées (Xa) s'étendent dans le second plan de la carte à circuit multi-plans, tandis que les n x 3 bobines plates de la seconde orientation (101b) s'étendent, sur la majeure partie de leur extension, dans le second plan et les zones de croisement associées s'étendent dans le premier plan de la carte à circuit multi-plans.

2. Dispositif de positionnement planaire selon la revendication 1,
dans lequel
une partie respective des extrémités de connexion (Ya, Yb) de toutes les bobines plates (101a, 101b) se situent dans le premier plan de la carte à circuit multi-plans, et une autre partie se situent dans le second plan de celle-ci.

3. Dispositif de positionnement planaire selon l'une des revendications précédentes,
dans lequel
toutes les bobines plates (101a, 101b) sont réalisées avec la même longueur et avec la même résistance ohmique.

4. Dispositif de positionnement planaire selon l'une des revendications précédentes,
dans lequel
toutes les bobines plates (101a, 101b) sont réalisées avec une extension de conduction de forme rectangulaire.

5. Dispositif de positionnement planaire selon l'une des revendications précédentes,
dans lequel
la petite zone de connexion (Ya, Yb) de la carte à circuit multi-plans occupe une surface inférieure à 10 %, en particulier inférieure à 5 % de la surface occupée par les bobines plates et est réalisée en particulier sous forme rectangulaire.

6. Dispositif de positionnement planaire selon l'une des revendications précédentes,
dans lequel
la carte à circuit multi-plans est une carte à circuit à deux plans.

7. Dispositif de positionnement planaire selon l'une des revendications précédentes,
dans lequel
l'ensemble de bobines (1 ; 101) recouvre la totalité de la surface du stator (9).

8. Dispositif de positionnement planaire selon l'une des revendications précédentes,
dans lequel
le moyen de détection de position (7, 8) comprend au moins une tête de mesure de position (8) disposée à l'intérieur du stator ou du rotor dans la position de fonctionnement du dispositif de positionnement, et une échelle de surface (7) fixée sur le rotor ou sur le stator dans une position précise, et le stator ou le rotor présente au moins une fenêtre (5) et de préférence une pluralité de fenêtres disposées en matrice pour rendre visible l'échelle de surface pour la tête de mesure de position.

9. Dispositif de positionnement planaire selon la revendication 8,
dans lequel
une partie au moins de la pluralité de fenêtres disposées en matrice sont disposées soit entre des bobines plates adjacentes desdites trois bobines plates respectives associées soit entre les n groupes adjacents respectifs de trois bobines plates respectives associées.

10. Dispositif de positionnement planaire selon l'une des revendications précédentes,
dans lequel
le rotor (3) comprend un arrangement en forme de damier de rangées d'aimants dont en particulier chacune forme un réseau d'Halbach (2), en particulier quatre rangées d'aimants disposées selon un arrangement en forme de damier.

11. Dispositif de positionnement planaire selon la revendication 10,
dans lequel
les rangées d'aimants recouvrent la zone centrale du rotor (3).

12. Table de positionnement (4) comportant un dispositif de positionnement planaire selon l'une des revendications précédentes, la table de positionnement comprenant des moyens de retenue et de guidage pour le dispositif de positionnement planaire et un support d'objet pour tenir un objet à positionner.

13. Ensemble d'usinage, en particulier machine-outil, comportant une table de positionnement (4) selon la revendication 12.

14. Ensemble de mesure comportant une table de positionnement (4) selon la revendication 12.
